# EUROPEAN PATENT APPLICATION

(11) **EP 4 848 340 A1**
(43) Date of publication of application: **02.12.2026**
(21) Application number: 25179098.6
(22) Date of filing: 27.05.2025
(51) Int. Cl.: H01L 23/31, H01L 23/495, H01L 23/48, H01L 21/48

(54) **PACKAGED SEMICONDUCTOR DEVICE HAVING A CONNECTING ELEMENT AND METHOD FOR MANUFACTURING IT**

(71) Applicant: NXP B.V., 5656 AG Eindhoven (NL)
(72) Inventor: Lictao Jr, Crispulo Estira, 5656AG Eindhoven (NL); Ruamwong, Wichit, 5656AG Eindhoven (NL)
(74) Representative: Colaiuda, Antonella

(57) **Abstract**

The present disclosure relates to a semiconductor packaged device and to a method for manufacturing it. The semiconductor packaged device comprises: a leadframe comprising a first lead and a die pad, a wirebond localized on the first lead encapsulated in an electrically conductive encapsulant material, a semiconductor die comprising a first major surface and a second major surface, wherein the first major surface is configured to be attached to the die pad, a connecting element comprising a first end and a second end, wherein the first end of the connecting element is configured to be connected to the second major surface of the semiconductor die and the second end of the connecting element is configured to be connected to the first lead via the encapsulated wirebond.

## Description

### TECHNICAL FIELD

The present disclosure relates to a packaged semiconductor device and a method for manufacturing it. Without being limited thereto, it is of particular significance for Quad Flat No-leads (QFN) packages.

### BACKGROUND

A QFN package is characterized by its square or rectangular shape and the absence of externally protruding leads. A QFN package usually comprises one or more wirebonds, a leadframe, a semiconductor die and encapsulant material. The wirebonds and leadframe provide electrical connections between the semiconductor die and the external faces of the QFN structure. Because of their compact size and the absence of external leads, the QFN packages are considered to be an optimal package solution for space-constrained devices.

### SUMMARY

Aspects of the disclosure are defined in the accompanying claims.

In a first aspect of the present disclosure, there is provided a packaged semiconductor packaged device comprising: a leadframe comprising a first lead and a die pad, a wirebond localized on the first lead, an electrically conductive encapsulant material at least partially encapsulating the wirebond, a semiconductor die comprising a first major surface and a second major surface, wherein the first major surface is configured to be attached to the die pad, a connecting element comprising a first end and a second end, wherein the first end of the connecting element is configured to be connected to the second major surface of the semiconductor die and the second end of the connecting element is configured to be connected to the first lead via the encapsulated localized wirebond.

In one or more embodiments of the first aspect of the present disclosure, a plurality of wirebonds encapsulated in the encapsulant material are localized on the first lead.

In one or more embodiments of the first aspect of the present disclosure, the second major surface of the semiconductor die is further configured to be attached to a second lead of the leadframe through an electrical connection.

In one or more embodiments of the first aspect of the present disclosure, the first lead and the second lead comprise contact pads.

In one or more embodiments of the first aspect of the present disclosure, the connecting element is a flat clip.

In one or more embodiments of the first aspect of the present disclosure, the encapsulated wirebond comprises a wire loop configured to be deformable.

In one or more embodiments of the first aspect of the present disclosure, the connecting element is configured to be coplanar and parallel to the semiconductor die.

In one or more embodiments of the first aspect of the present disclosure, the first major surface of the semiconductor die is configured to be attached to the die pad via an adhesive.

In one or more embodiments of the first aspect of the present disclosure, wherein the second major surface of the semiconductor die is configured to be attached to the first end of the connecting element via an adhesive or a solder material.

In a second aspect of the present disclosure, a method for manufacturing a packaged semiconductor device comprising a semiconductor die with a first major surface and a second major surface is described. The method comprises the steps of: forming a leadframe comprising a die pad and a lead, attaching the first major surface of the semiconductor die to the die pad, forming a wirebond on the lead, encapsulating the wirebond with adhesive or solder material, providing a connecting element having a first end and a second end, connecting the first end of the connecting element to the second major surface of the semiconductor die, connecting the second end of the connecting element with the encapsulated wirebond.

In one or more embodiments of the second aspect of the present disclosure, connecting the second end of the connecting element with the encapsulated wirebond comprises the step of deforming the encapsulated wirebond.

In one or more embodiments of the second aspect of the present disclosure, the first major surface of the semiconductor die is attached to the die pad via an adhesive.

In one or more embodiments of the second aspect of the present disclosure, the second major surface of the semiconductor die is attached to the connecting element via an adhesive or a solder material.

In one or more embodiments of the second aspect of the present disclosure, the method further comprises the step of encapsulating the semiconductor die, the encapsulated localized wirebond and the connecting element with an encapsulant material.

In a third aspect of the present disclosure, an array comprising a plurality of packaged semiconductor devices is described. The packaged semiconductor devices are connected by interconnecting elements via the connecting elements.

### DESCRIPTION OF DRAWINGS

Embodiments of the present disclosure will be described in more detail with reference to the appended drawings, in which:
Figure 1a shows a packaged semiconductor device according to a first embodiment of the present disclosure.
Figure 1b shows a simplified picture of a lead of the semiconductor device according to the first embodiment of the present disclosure.
Figure 1c shows a simplified picture of a wirebond according to the first embodiment of the present disclosure.
Figures 2a to 2f show a manufacturing method for the packaged semiconductor device according to the first embodiment of the present disclosure.
Figure 3 shows a semiconductor packaging device according to a second embodiment of the present disclosure.
Figure 4 shows a manufacturing method for the semiconductor packaging device according to the second embodiment of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### DESCRIPTION OF EMBODIMENTS

QFN packages often use flat connecting elements (also known as flat clips) to provide high conductivity electrical connection between a surface of a semiconductor die and leads of the leadframe. For ease of manufacture, and in particular to provide for good solder contact, the flat clips are typically required to be co-planar and parallel with the surface of the semiconductor die. Because of this requirement, the leads of the leadframe and the semiconductor die surface should have the same height. This requires dedicated (non-flexible) designs. To realize such designs special tools are required: those tools allow for down setting and/or forming the leads of the leadframe in such a way that the height difference between the semiconductor die surface and the leads is compensated, allowing the flat clip to stay co-planar and parallel with the semiconductor die surface. However, the use of such tools augments the manufacturing costs and prolongs the manufacturing time.

The present application provides a solution to the problem above by forming a pedestal on the lead that allows for attaching the flat clip in a way which preserves the co-planarity and parallelism between the semiconductor die surface and the flat clip.

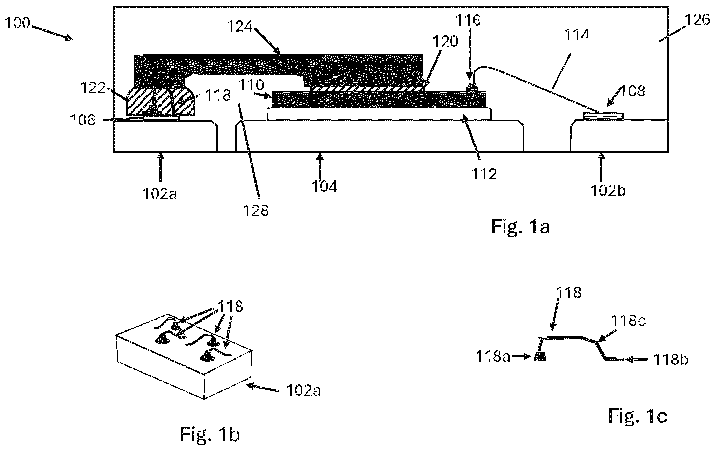

Fig. 1a shows a packaged semiconductor device according to a first embodiment of the present disclosure. The packaged semiconductor device may be a quad-flat-no leads packaging device. The packaged semiconductor device includes a leadframe including a first lead 102a and a second lead 102b. The leadframe is typically formed from copper, and the first lead 102a and the second lead 102b may further include a contact pad 106, 108, for instance of electroplated silver. The leadframe further includes a die pad 104. The first lead 102a, the second lead 102b and the die pad 104 are co-planar with each other. The semiconductor packaged device further includes a semiconductor die 110, having a first major surface and a second major surface. The first major surface of the semiconductor die is configured to be attached to the die pad 104 via an adhesive 112. The use of adhesives is particularly convenient if two components of different materials are bonded together. In some applications, electrical connection is provided to the first surface, which may also be referred to as the rear surface, of the semiconductor die through the die pad. In such applications, the adhesive is typically an electrically conductive adhesive such as a conductive epoxy. The second lead 102b may be connected to the second major surface of the semiconductor die via an electrical connection 114, for example a wirebond. The wirebond includes a first end part 116 attached to the second major surface of the semiconductor device. The first end part 116 is connected to the contact pad 108 via a wire. The first end part 116 may be referred to as stud or bump. Depending on the manufacturing process used (ball-bonding, ribbon bonding or wedge-bonding), the first end part 116 may have of a variety of cross-sectional shapes, including a circular cross-section, a substantially rectangular cross-section, a stadium (or pillar-shape) cross-section, a trapezoidal cross-section, or the like. The first end part 116 and the wire may be constructed of copper or silver, aluminum, gold, platinum, palladium, or by combinations of such or other conductors. The electrical connection 114 allows for an electric connection between the second lead 102b and the semiconductor die 110.

The semiconductor packaged device of Fig. 1a further includes a connecting element 124. The connecting element has a first end, a second end and a flat horizontal element comprised between the first end and the second end. The first end and the second end of the connecting element may be referred to as first foot and second foot of the connecting element. The connecting element may be referred to as clip, or as "clip bond", and is preferably a flat clip bond. The connecting element may be constructed of copper, silver, aluminum, gold, platinum, palladium, or by combinations of such or other conductors. The clip bond or connecting element provides a thermal and electrical connection between the semiconductor die and the first lead. In contrast to conventional wirebonding, clip bonds have a better thermal conductivity, which may improve the heat dissipation of the semiconductor packaged device. In addition, because of their lower electrical resistance, the clip bonds may improve the efficiency of the semiconductor packaged device. Moreover, the clip bonds are mechanical robust. The first end of the connecting element 124 is configured to be connected to the second major surface of the semiconductor die via a conductive adhesive, such as a conductive epoxy, or a solder material 120. The second end of the connecting element 124 is configured to be attached to the first lead 102a, as it will be explained in the following. A recess 128 may be formed among the first lead, the die pad and the clip bond. The first lead 102a includes, thereon, at least one localized wirebond 118, preferably a plurality of localized wirebonds. In contrast to conventional wirebonding between a lead and the semiconductor die, according to one or more embodiments of the present disclosure, the wirebond or wirebonds associated with the first lead 102a are localized, by which is meant that both the heads and the ends of the wirebonds are located on the first lead, as it will be explained later. This may have the effect of creating an electrical connection between the lead and itself. The localized wirebonds may be created by a ball bonding a first end of the wirebond to the lead, instead of the semiconductor die, forming a short wire loop, and bonding a second end of the wirebond to the same lead. During manufacturing process, the wirebond height may be adjusted according to the height of the semiconductor die 110. Thus, in general, the wirebond height in the localized wirebond 118 will be set to be the same, or approximately same, as the height of the second (active) surface of the semiconductor die 110. This may have the effect of accounting for a difference in height between the second major surface of the semiconductor die and the first lead, preserving in this way the co-planarity and parallelism of the connecting element 124 with the semiconductor die 110. Including a plurality of localized wirebonds may have the effect of increasing the mechanical support for the second end of the connecting element.

The one or more localized wirebonds 118 are then at least partially encapsulated in an electrically conductive encapsulant material 122, like an adhesive or a solder material. The encapsulated localized wirebonds 118 form a pedestal for the second end of the connecting element 124 and act as a mechanical stopper for the connecting element 124. This has the effect of giving a better mechanical support to the connecting element 124. The electrically conductive encapsulant material 122 may contain tin, copper, silver, bismuth, indium, zinc, antimony or any other types of suitable metal or alloy. In addition, the electrically conductive encapsulant material may be formed by any combinations of the materials listed above. The electrically conductive encapsulant material may have the effect of reinforcing and stabilizing the connection between the connecting element 124 and the first lead 102a. The electrically conductive encapsulant material 122 and/or the wirebond 118 may be configured to be deformable and may then be slightly deformed when they are connected to the second end of the connecting element: this may help preserving the coplanarity and parallelism of the connecting element with the semiconductor die. In particular, the loop of the wirebond 118 may be deformable: for example, the loop of the wirebond 118 may be flattened, i.e. it may reach the same height as the wirebond head, when connected to the second end of the connecting element, as the second end of the connecting element "compress" the loop. By flattening the loop of the wirebond, a wider area is formed, which may give additional mechanical support to the connecting element. A further effect of using encapsulated localized wirebonds may be that the first end of the connecting element does not need to have a special form (for example to be bent) for taking into account the difference in height between the second major surface of the semiconductor die and the first lead. In addition, the horizontal element of the connecting element may be formed without a recess among the first end and the second end, i.e. it may be a straight component between the first end and the second end.

An encapsulant material 126, also referred to as molding compound, is deposited on the leadframe and encapsulated the electrical connection 114, the connecting element 124, the encapsulated localized wirebond 118, the first lead 102a, the second lead 102b and the semiconductor die 110. The side and bottom part of the first lead and the second lead are exposed, i.e. the encapsulant material 126 does not encapsulated those parts. The encapsulant material may be made by silicones, polyimides or epoxy molding compounds.

Fig. 1b shows a simplified view of the first lead 102a. In the embodiment represented in Fig. 1b a plurality of wirebonds 118 is attached to the first lead 102a. The plurality of wirebonds may be disposed in different configurations on the first lead 102a, according to their number and form. For example, the wirebonds may be disposed on the first lead 102a forming a rectangular shape, a quadratic shape or any other type of shape which may be suitable to increase the mechanical support. Additionally, or alternatively, the wirebonds may be disposed on the first lead according to a same orientation or one or more different orientations. A schematic view of a wirebond 118 is shown in Fig. 1c. The wirebond 118 has a first element 118a, which may be referred to as head, ball bond, bump or stud, and a second element 118b that may be referred to as foot of the wirebond. The head of the wirebond is connected by a wire 118c to the foot of the wirebond. Both the head and the foot of the wirebond are located on the first lead 102a and may be connected to contact pad 106. In other words, the head and foot of the wirebond 118 are both located on the first lead 102a. The head of the wirebond may have of a variety of cross-sectional shapes, including a circular or elliptical cross-section, a substantially rectangular cross-section, a stadium (or pillar-shape) cross-section, an n-sided polygonal cross-section, or the like. The wirebond may be constructed of copper or silver, aluminum, gold, platinum, palladium, or by combinations of such or other conductors. The height of the wirebond may be adjusted to accommodate the difference in height between the first lead 102a and the second major surface of the semiconductor die 110.

In one embodiment, the head of the wirebond 118 may be formed by two stacked ball bonds or bumps. Such heads may be referred to as double-bump. Double-bumps may have the effect of easily compensate for height differences between the first lead 102a and the second major surface of the semiconductor die 110. In addition, using double-bumps may have the effect of avoiding shorting or interference with nearby structures. Additionally, the second bump may enhance mechanical strength and electrical contact, especially in high-reliability applications.

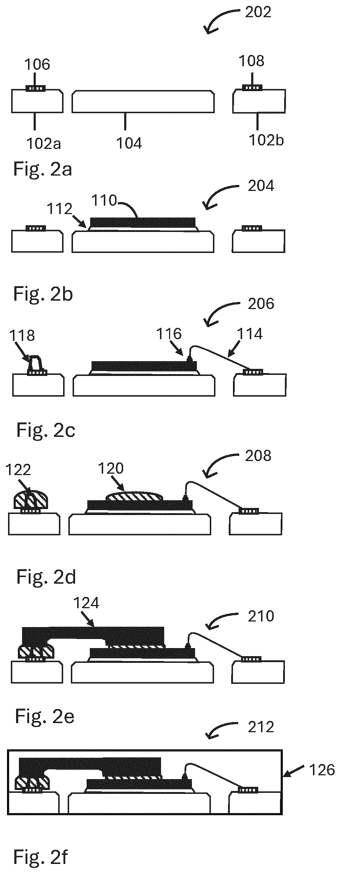

A process for manufacturing a semiconductor packaged device according to the first embodiment of the present disclosure is described in Fig. 2a to Fig. 2f. In a first step 202, a leadframe including first lead 102a, second lead 102b and die pad 104 is provided. The first lead 102a and the second lead 102b may respectively include contact pads 106, 108. In a second step 204, a semiconductor die 110, having a first major surface and a second major surface, is attached to the die pad 104 via an adhesive 112. In a third step 206, the wirebond 118 and the electrical connection 114 are formed respectively on the first lead 102a and on the second major surface of the semiconductor die 110. The wirebond 118 and the electrical connection 114 may be formed via wire bonding techniques like ball-bonding or wedge-bonding. For a ball-bonding method a bonding machine having a capillary is used. A wirebond is then guided through the capillary. An electrical spark is used to form a ball at the end of the wirebond. The ball is pressed or squashed against a first bonding surface (for example the contact pad 106) under the application of appropriate techniques like thermo-compression, ultrasonic compression or thermosonic compression, establishing a first bonding element which may have the form of a stud or bump. The capillary is moved to the second bonding surface (which in the case of the wirebond 118 coincides with the first bonding surface) where the wire is bonded by the same forces as explained above, using the rim of the capillary to form the foot of the wirebond. The capillary is then removed, and the wire is clamped. If a double-bump is formed, then after creating the first ball as explained above, the capillary is lifted slightly, and a second ball is formed and bonded on top of the first. The wire is then routed to the second bonding surface and clamped.

In a fourth step 208, an adhesive or a solder material 120 is deposited on the second major surface of the semiconductor die 110. An electrically conductive encapsulant material 122 is deposited on the first lead 102a, so that the one or more wirebonds 118 are encapsulated in the electrically conductive encapsulant material 122. The encapsulated localized wirebonds 118 form in such a way a pedestal. In a fifth step 210, the connecting element 124 is added to the semiconductor packaged device. The first end of the connecting element is attached to the second major surface of the semiconductor die 110 via adhesive or solder material 120 and the second end of the connecting element is attached to the first lead 102a via the pedestal formed by the wirebonds 118 encapsulated in the electrically conductive encapsulant material 122. When attached on the adhesive or solder material 120 and on the encapsulated localized wirebond 118, the connecting element 124 may then deform both. In a sixth step 212, an encapsulant material is deposited on the leadframe and encapsulates the electrical connection 114, the connecting element 124, the encapsulated localized wirebond 118, the first lead 102, the second lead 102b and the semiconductor die 110.

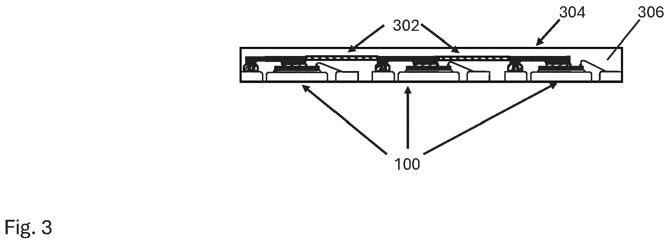

Fig 3. shows an array of semiconductor devices according to a second embodiment of the present disclosure. In this embodiment several packaged semiconductor devices 100, according to the configuration described in Fig. 1a, are attached on a leadframe carrier. The packaged semiconductor devices100 are connected to each other via an interconnecting element 302. The interconnecting element 302 connects two connecting elements 124. The interconnecting element 302 is collinear with the connecting element 124 and may have the same composition as the connecting element. The interconnecting element 302 and the connecting element 124 forms a continuous bar or strip. The continuous bar of connecting elements and interconnecting elements may be prefabricated. Because each connecting element 124 is coupled to each first lead 102a via the pedestal formed by the encapsulated localized wirebond 118, as explained in Fig. 1a, the continuous bar is maintained parallel and co-planar with each semiconductor die 110. An encapsulant material 306 may encapsulate the array of semiconductor devices.

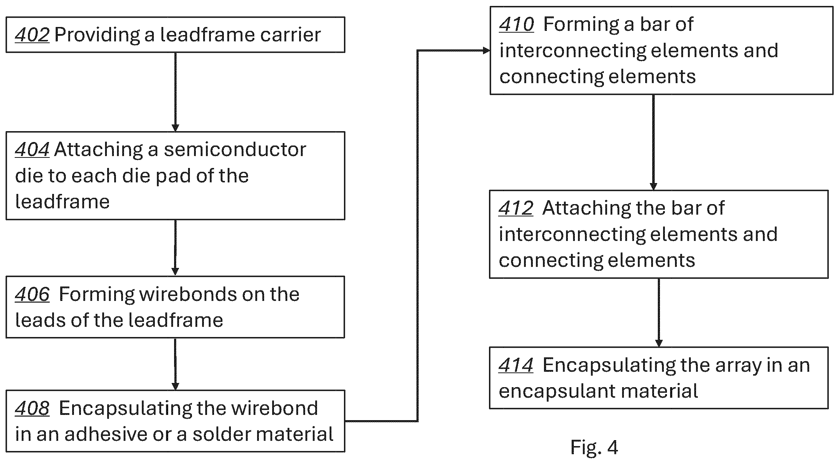

Fig. 4 describes a manufacturing process for manufacturing the array of semiconductor packaged devices 100 described in Fig. 3. In a first step 402, a leadframe carrier or leadframe is provided. The carrier leadframe includes multiple die pads and leads. Each die pad may be surrounded by at least a first lead and a second lead. In a second step 404, a semiconductor die is attached on each die pad of the leadframe. In a third step 406, the localized wirebonds 118 are formed on each first lead of the leadframe. Parallel to this step the electrical connection 114, which connects the second lead, and the semiconductor die, may be formed too. In a fourth step 408, the wirebonds 118 are encapsulated in an adhesive or a solder material. In a fifth step, a strip or bar of connecting elements and interconnecting elements is formed. In particular, at least two connecting elements, each having a first end, a second end and a horizontal part between the first end and the second end, are coupled together via an interconnecting element. In a sixth step 412, the strip of connecting elements 124 and interconnecting elements 302 is then attached to the array of packaged semiconductor devices100. The strip may be pressed on the array of semiconductor packaged devices 100, in such a way that the first end of each connecting element 124 is attached to the second major surface of one of the semiconductors dies and the second end of each connecting element is attached to one of the first leads via the encapsulated localized wirebond. Using a strip of connecting elements and interconnecting elements as explained above, may have the effect of avoiding to singulate each of the connecting elements 124 separately before mounting them on the semiconductor die and on the lead as explained in the fifth step 210. This may simplify the manufacturing process and lower the cost of manufacturing the packaged semiconductor device 100. In a seventh step 414, the array of semiconductor devices is encapsulated in an encapsulant material 306.

From reading the present disclosure, other variations and modifications will be apparent to the skilled person. Such variations and modifications may involve equivalent and other features which are already known in the art of semiconductor device processing, and which may be used instead of, or in addition to, features already described herein.

Although the appended claims are directed to particular combinations of features, it should be understood that the scope of the disclosure of the present specification also includes any novel feature or any novel combination of features disclosed herein either explicitly or implicitly or any generalization thereof, whether or not it relates to the same specification as presently claimed in any claim and whether or not it mitigates any or all of the same technical problems as does the present specification

The present disclosure refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness, it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to. Unless stated otherwise, terms such as "first" and "second" are used to arbitrarily distinguish between the elements such terms describe. Thus, these terms are not necessarily intended to indicate temporal or other prioritization of such elements.

## Claims

1. A packaged semiconductor device comprising:
a leadframe comprising a first lead and a die pad;
a wirebond localized on the first lead;
an electrically conductive encapsulant material at least partially encapsulating the localized wirebond;
a semiconductor die comprising a first major surface and a second major surface, wherein
the first major surface of the semiconductor die is configured to be attached to the die pad;
a connecting element comprising a first end and a second end;
wherein the first end of the connecting element is configured to be connected to the second major surface of the semiconductor die and the second end of the connecting element is configured to be connected to the first lead via the encapsulated localized wirebond.

2. The packaged semiconductor device according to claim 1, wherein a plurality of localized wirebonds is located on the first lead.

3. The packaged semiconductor device according to claim 1 or claim 2, wherein the second major surface of the semiconductor die is further configured to be attached to a second lead of the leadframe through an electrical connection.

4. The packaged semiconductor device according to any preceding claim, wherein the first lead and the second lead comprise contact pads.

5. The packaged semiconductor device according to any preceding claim, wherein the connecting element is a flat clip.

6. The packaged semiconductor device according to any preceding claim, wherein the encapsulated localized wirebond comprises a wire loop configured to be deformable.

7. The packaged semiconductor device according to any preceding claim, wherein the connecting element is configured to be coplanar and parallel to the semiconductor die.

8. The packaged semiconductor device according to any preceding claim, wherein the first major surface of the semiconductor die is configured to be attached to the die pad via an adhesive or solder material.

9. The packaged semiconductor device according to any preceding claim, wherein the second major surface of the semiconductor die is configured to be attached to the first end of the connecting element via an adhesive.

10. A method for manufacturing a packaged semiconductor device comprising a semiconductor die with a first major surface and a second major surface, the method comprising the steps of:
forming a leadframe comprising a die pad and a first lead,
attaching the first major surface of the semiconductor die to the die pad,
forming a wirebond localized on the first lead,
encapsulating the localized wirebond with an electrically conductive encapsulant material,
providing a connecting element having a first end and a second end,
connecting the first end of the connecting element to the second major surface of the semiconductor die,
connecting the second end of the connecting element to the first lead via the encapsulated localized wirebond.

11. The method of claim 10, further comprising connecting the second major surface of the semiconductor die to a second lead of the leadframe through an electrical connection.

12. The method according to claim 10 or claim 11, wherein the first major surface of the semiconductor die is attached to the die pad via an adhesive.

13. The method according to any of claims 10 to 12, wherein the second major surface of the semiconductor die is attached to the first end of the connecting element via an adhesive or solder material.

14. The method according to any of claims 10 to 13, further comprising the step of encapsulating the semiconductor die, the encapsulated wirebond, the electrical connection, the first lead, the second lead and the connecting element with an encapsulant material.

15. An array comprising a plurality of packaged semiconductor devices according to any of claim 1 to 9, wherein at least two connecting elements are connected with each other via an interconnecting element.
